# EUROPEAN PATENT SPECIFICATION

(11) **EP 1 856 214 B1**
(45) Date of publication and mention of the grant of the patent: **29.09.2010**
(21) Application number: 06720805.8
(22) Date of filing: 16.02.2006
(51) Int. Cl.: C09D 4/00, C09D 163/00, C09D 171/00

(54) **ENERGY-CURABLE COATING COMPOSITIONS**
ENERGIE-HÄRTBARE BESCHICHTUNGSZUSAMMENSETZUNGEN
Compositions de revêtement durcissables énergétiquement

(30) Priority: 25.02.2005 GB 0503948
(43) Date of publication of application: 21.11.2007
(73) Proprietor: Sun Chemical Corporation, Parsippany, NJ 07054-1285 (US)
(72) Inventor: HERLIHY, Shaun Lawrence, Chatham, Kent ME5 9DD (GB); STANDING, Stephen Stuart, Orpington, Kent BR6 6BD (GB); DAVIDSON, Robert Stephen, Leicester LE5 2GG (GB)
(74) Representative: Schwahn, Hartmut
(86) International application number: PCT/US2006/005443
(87) International publication number: WO 2006/093678

(56) References cited:
- EP-A- 1 348 727
- US-A1- 2003 158 286
- DATABASE WPI Section Ch, Week 199931 Derwent Publications Ltd., London, GB; Class A21, AN 1999-367209 XP002396685 & JP 11 140279 A (TOA GOSEI CHEM IND LTD) 25 May 1999 (1999-05-25)
- DATABASE WPI Section Ch, Week 199909 Derwent Publications Ltd., London, GB; Class A21, AN 1999-101272 XP002396686 & JP 10 330652 A (KANSAI PAINT CO LTD) 15 December 1998 (1998-12-15)

## Description

The present invention relates to energy-curable coating compositions, such as printing inks or varnishes, having excellent cure and, if desired, a relatively low viscosity, as a result of the incorporation in the composition of unprecedentedly high levels of cyclic carbonates.

Although cationic curing of printing inks on exposure to ultraviolet radiation (UV) by the ring-opening polymerisation of epoxides has been known for a very long time, it has never achieved much commercial success, as a result, *inter alia,* of the slow cure speed of such systems. In order to make such systems commercially attractive, it is necessary to improve the cure speed of UV cationically curable epoxide-based printing inks and similar coating compositions.

We have surprisingly found that this may be achieved by the incorporation in the coating composition of relatively high levels of one or more cyclic carbonates, such as propylene carbonate. This finding is the more surprising, since propylene carbonate, in particular, is commonly used as a solvent for the cationic photoinitiator in such systems (the cationic photoinitiator commonly being used as a 50% solution in propylene carbonate) and since there is pressure from users of these coating compositions to reduce the level of propylene carbonate, on the basis that it may migrate out of the cured composition. Moreover, propylene carbonate is deemed by most formulators and end users to be an unreactive component, and so it would not be expected to have a positive effect on cure. Indeed, US Patent No. 5,262,449 is not alone in stating specifically that simple alkylene carbonates are merely solvents and play no part in polymerisation, and that they should be used in relatively low amounts to avoid undesired effects.

Since the level of propylene carbonate in prior art compositions is determined by the level of cationic photoinitiator, it is readily possible to determine the levels of propylene carbonate in the resulting compositions. In general, sulphonium salt cationic photoinitiators have been used in the prior art at levels of from 8 to 10% by weight, and so the level of propylene carbonate in such compositions would be from 4 to 5% by weight.

EP1 348 727 A discloses an image-receiving layer composition, comprising an epoxy compound, an oxetane compound, and a photo-cationic polymerization initiator.

JP 11 140279 A discloses an active-curing composition, which comprises an oxetane compound, a compound having at least two epoxy components and a cationic photo polymerization initiator.

US 2003/158286 A1 discloses an active energy beam-curable composition comprising an epoxy compound, an oxetane compound, a photo-cationic polymerization initiator, a pigment, and a pigment dispersing agent.

JP 10 330652 A discloses an activated energy ray-curable powder paint composition, which comprises a resin compound having oxetane, a polyepoxide, and a photo-cationic polymerization initiator.

Carroy ["New Developments in Cationic Curing Flexo Inks", a paper presented at RadTech e/5 2004 Technical Proceedings] discloses a composition containing about 13.4% propylene carbonate, but attributes the results achieved to the excellent thioxanthonium cationic photoinitiator which be used and its good dissolution in the printing ink. Specifically, the composition disclosed by Carroy comprises 57.1% 3,4-epoxy-cyclohexylmethyl-3',4'-epoxycyclohexane carboxylate, 10.0% 3-ethyl-3-hydroxmethyl-oxetane, 15.0% pigment, 17.4% 10-biphenyl-4-yl-2-isopropyl-9-oxo-9H-thioxanthen-10-ium hexafluorophosphate as a 23% solution in propylene carbonate, and 0.5% levelling additive.

JP 2004-32361 (Konica Minolta) also discloses a coating composition for ink jet use that contains either a cyclic ester compound (in an amount between 2.5 and 20 mass%, preferably between 5.0 and 15 mass%, of the total ink mass) or propylene carbonate (in unspecified amounts).

In accordance with the present invention, we have found that significantly higher levels of a cyclic carbonate, such as propylene carbonate, than are conventionally used are needed in order to achieve the desired enhanced cure speed.

The present invention provides an energy-curable coating composition comprising an epoxide monomer or ligomer, a cationic photoinitiator and a cyclic carbonate, provided that the composition does not comprise 57.1% 3,4-epoxycyclohexylmethyl-3',4'-epoxycyclohexane carboxylate, 10.0% 3-ethyl-3-hydroxymexhyl-oxetane, 15.0% pigment, 17.4% biphenyl-4-yl-2-isopropyl-9-oxo-9H-thioxanthen-10-ium hexafluorophosphate as a 23% solution in propylene carbonate, and 0.5% leveling additive, and provided that when propylene carbonate is the only cyclic carbonate present, it is in an amount of at least 12% by weight of the entire composition.

In a variant of the present invention there is provided an energy-curable coating composition comprising an epoxide monomer or oligomer, a cationic photoinitiator and a cyclic carbonate other than propylene carbonate.

The composition both may also contain an oxetane monomer or oligomer. These compounds are capable of polymerising by a cationically induced ring-opening reaction. Examples of suitable oxetanes include 3-ethyl-3 hydroxymethyl-oxetaae or 3-ethyl-3-[2-ethylhexyloxy)-methyl]oxetane. However, the compositions of the present invention are preferably free from added mono-functional oxetanes.

Typical epoxides which may be used include the cycloaliphatic epoxides (such as those sold under the designations Cyracure UVR6105, UVR6107, UVR6110 and UVR6128, by Dow), which are well known to those skilled in the art.

Other epoxides which may be used include such epoxy-functional oligomers/monomers as the glycidyl ethers of polyols [bisphenol A, alkyl diols or poly(alkylene oxides), which be di-, tri-, tetra- or hexa- functional]. Also, epoxides derived by the epoxidation of unsaturated materials may also be used (e.g. epoxidised soybean oil, epoxidised polybutadiene or epoxidised alkenes). Naturally occurring epoxides may also be used, including the crop oil collected from Vernonia galamensis.

As well as epoxides and optionally oxetanes, other reactive monomers/oligomers which may be used include the vinyl ethers ofpolyols [such as triethylene glycol divinyl ether, 1,4-cyclohexane dimethanol divinyl ether and the vinyl ethers of poly(alkylene oxides)J. Examples of vinyl ether functional prepolymers include the urethane-based products supplied by Allied Signal. Similarly, monomers/oligomers containing propenyl ether groups may be used in place of the corresponding compounds referred to above containing vinyl ether groups.

Other reactive species can include styrene derivatives and cyclic esters (such as lactones and their derivatives).

The composition of the present invention also contains a cationic photoinitiator. There is no particular restriction on the particular cationic photoinitiator used, and any cationic photoinitiator known in the art may be employed. Examples of such cationic photoinitiators include sulphonium salts (such as the mixture of compounds available under the trade name UVI6992 from Dow Chemical), thianthrenium salts (such as Esacure 1187 available from Lamberti), iodonium salts (such as IGM 440 from IGM) and phenacyl sulphonium salts. However, particularly preferred cationic photoinitiators are the thioxanthonium salts, such as those described in WO 03/072567 A1, WO 03/072568 A1, and WO 2004/055000 A1.

Particularly preferred thioxanthonium salts are those of formulae (I), (II) and (III):

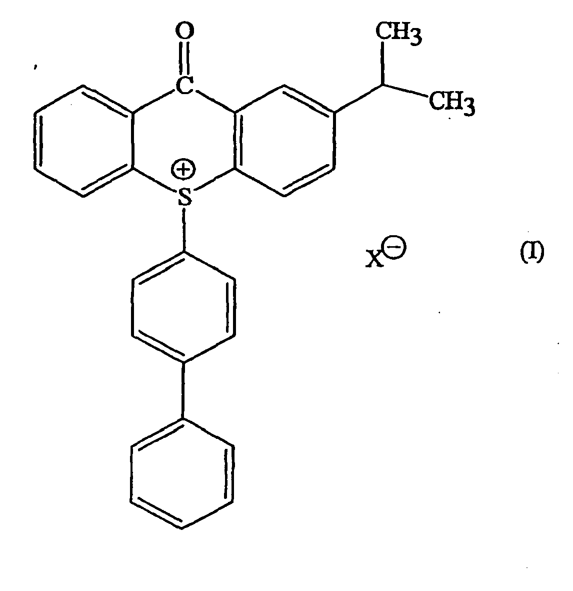

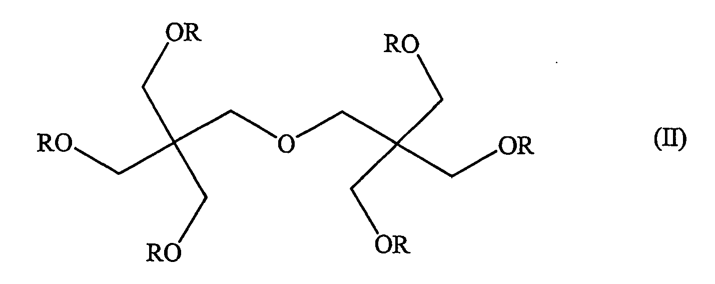

R-(OCH₂CH₂CH₂CH₂)ₙ-OR (III)

in which each R represents a group of formula (IV): 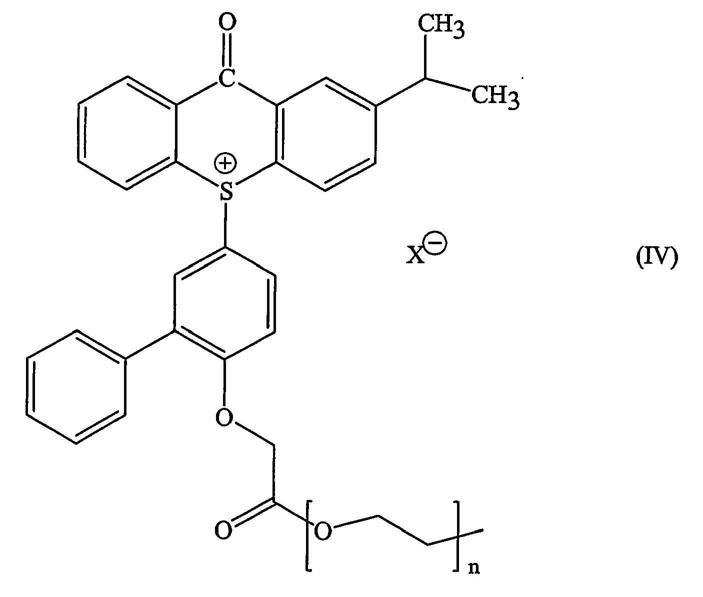 where n is a number and X⁻ is an anion, especially the hexafluorophosphates. The hexafluorophosphates of the compounds of formulae (I) and (II) are available from Robinson Brothers Ltd. under the trade marks "Meerkat" and "Bobcat", respectively, or from IGM under the trade marks IGM 550 and IGM 650 respectively.

The compositions of the present invention also contain a cyclic carbonate at a level higher than is conventionally used, when it is merely present as a solvent for the cationic photoinitiator, i.e. at a level of at least 7% by weight of the entire composition, preferably at least 8% by weight of the entire composition, more preferably at least 10% by weight of the entire composition, and most preferably at least 15% by weight of the entire composition. The amount of cyclic carbonate can go up to very high levels, far beyond what would previously have been considered sensible, even as far as 40% by weight of the entire composition, although, at such a level, its presence will tend to degrade the properties of the cured coating composition, and a more reasonable maximum is 35%, still more preferably 30%. In a preferred embodiment, the cyclic carbonate is present in an amount of from 12% to 35% by weight of the entire composition. In another preferred embodiment the cyclic carbonate is present in an amount of from 12% to 30% by weight of the entire composition. In another preferred embodiment the cyclic carbonate is present in an amount of from 12% to 25% by weight of the entire composition. In another preferred embodiment the cyclic carbonate is present in an amount of from 15% to 35% by weight of the entire composition. In another preferred embodiment the cyclic carbonate is present in an amount of from 15% to 25% by weight of the entire composition. In another preferred embodiment the cyclic carbonate is present in an amount of from 8% to 35% by weight of the entire composition. In another preferred embodiment the cyclic carbonate is present in an amount of from 10% to 30% by weight of the entire composition.

The cyclic carbonate used may be any known in the art, preferably one that can act as a solvent for at least some part of the composition of the present invention prior to curing. Preferred cyclic carbonates are those having a 5-membered ring. Examples of suitable cyclic carbonates include compounds of formula (V): 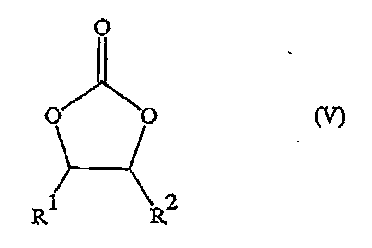 in which R¹ and R² are the same as or different from each other and each represents a hydrogen atom, a C₁ - C₃ alkyl group, a C₁ - C₃ hydroxyalkyl group or a C₂ - C₃ alkenyl group.

Where R¹ and/or R² represents an alkyl group, this may be, for example, a methyl, ethyl, propyl or isopropyl group, the methyl group being preferred. Where R¹ and/or R² represents a hydroxyalkyl group, this may be, for example, a hydroxymethyl, 1-hydroxyethyl, 2-hydroxyethyl, 2-hydroxypropyl or 3-hydroxypropyl group, the hydroxymethyl group being preferred. Where R¹ and/or R² represents an alkenyl group, this may be a vinyl or allyl group, the vinyl group being preferred.

Specific examples of such cyclic carbonates include propylene carbonate, glycerine carbonate, vinyl ethylene carbonate, ethylene carbonate and butylene carbonate, of which propylene carbonate is preferred.

The composition of the present invention may be formulated as a printing ink, varnish, adhesive, paint or any other coating composition which is intended to be cured by energy, which may be supplied by irradiation, whether by ultraviolet or electron beam. Such compositions will normally contain at least a polymerisable monomer, prepolymer or oligomer, and a cationic photoinitiator, as well as the cyclic carbonate, but may also include other components well known to those skilled in the art, for example, reactive diluents and, in the case of printing inks and paints, a pigment or dye.

It is also common to include polyols in ultraviolet cationic curable formulations, which promote the cross-linking by a chain-transfer process. Examples of polyols include the ethoxylated/propoxylated derivatives of, for example, trimethylolpropane, pentaerythritol, di-trimethylolpropane, di-pentaerythritol and sorbitan esters, as well as more conventional poly(ethylene oxide)s and poly(propylene oxide)s. Other polyols well known to those skilled in the art are the polycaprolactone diols, triols and tetraols, such as those supplied by Dow.

Additives which may be used in conjunction with the principal components of the coating formulations of the present invention include stabilisers, plasticisers, pigments, waxes, slip aids, levelling aids, adhesion promoters, surfactants and fillers.

The amounts of the various components of the curable composition of the present invention may vary over a wide range and, in general, are not critical to the present invention. However, we prefer that the amount of the polymerisable components (i.e. the epoxide, oxetane, if used, and other monomers, prepolymers and oligomers, if used) should be from 40 to 90% of the total composition. The epoxide(s) preferably comprise from 30 to 80% of the polymerisable components in the composition of the present invention, and the oxetanes, preferably multi-functional oxetane(s), if used, preferably comprise from 5 to 40% of the polymerisable components in the composition of the present invention. The amount of cationic photoinitiator is normally from 1.0 to 10% by weight, more preferably from 2.0 to 8%, by weight of the entire composition.

Other components of the curable composition may be included in amounts well known to those skilled in the art.

The curable compositions of this invention may be suitable for applications that include protective, decorative and insulating coatings; potting compounds; sealants; adhesives; photoresists; textile coatings; and laminates. The compositions may be applied to a variety of substrates, e.g., metal, rubber, plastic, wood, moulded parts, films, paper, glass cloth, concrete, and ceramic. The curable compositions of this invention are particularly useful as inks for use in a variety of printing processes, including, flexography, inkjet and gravure. Details of such printing processes and of the properties of inks needed for them are well known and may be found, for example, in The Printing Ink Manual, 5th Edition, edited by RH. Leach et al., published in 1993 by Blueprint.

Where the compositions of the present invention are used for inks, these typically comprise, as additional components to those referred to above, one or more of pigments, waxes, stabilisers, and flow aids, for example as described in "The Printing Ink Manual".

Thus, the invention also provides a process for preparing a cured coating composition, which comprises applying a composition according to the present invention to a substrate and exposing the coated substrate to curing radiation such as ultraviolet sufficient to cure the coating.

The invention is further illustrated by the following Examples. Percentages are by weight.
Further particular embodiments of the invention are set forth in the dependent claims.

"Cyracure", "Esacure", "Meerkat", "Bobcat", "Tegorad", "Jeffsol", "Uricure", "Irgacure", "Solsperse", "Airex", "Finnititan", "Easiproof", and "RAPICURE" are acknowledged as registered trademarks.

### EXAMPLE 1

Varnish formulations were prepared based on 2% Meerkat photoinitiator, 0.1% Tegorad 2100 wetting aid, variable levels of propylene carbonate (as shown in Table 1), with the remainder being UVR6105 cycloaliphatic epoxide. AU formulations were printed using a number 1K bar onto Leneta charts and cured with a single pass at 100 m/min using 1x 118 W/cm (300 W/inch) medium pressure mercury lamp operating at half power. Cure was assessed using the well known MEK (methyl ethyl ketone) solvent rub method immediately after cure, 5 minutes after cure and 15 minutes after cure. The results are shown in the following Table 1.

| % propylene carbonate | MEK double rubs | | |
|---|---|---|---|
| | Immediate | T=5 minutes | T=15 minutes |
| 1 | 7 | 10 | 11 |
| 5 | 6 | 21 | 30 |
| 10 | 7 | 29 | 48 |
| 15 | 9 | 48 | > 50 |
| 20 | 13 | > 50 | > 50 |
| 25 | 11 | 30 | 46 |
| 30 | 9 | 14 | 22 |
| 40 | 7* | 5 | 9 |
| 50 | 5* | 3* | 5 |

| | | | |
|---|---|---|---|
| * coating tacky or wet • *The photoinitiator Meerkat (10-biphenyl-4-yl-2-isopropyl-9-oxo-9H-thioxanthen-10-ium hexafluorophosphate) was obtained from Robinson Brothers* • *Tegorad 2100 is a wetting aid obtained from the Tego Corporation* • *The cycloaliphatic epoxide resin UVR6105 (3,4-epoxycyclohexylmethyl 3,4-epoxycyclohexane carboxylate) was obtained from DOW* • *Propylene carbonate was obtained from Aldrich* | | | |

These results indicate that, far from behaving as an inert solvent, propylene carbonate is providing a substantial cure benefit in terms of the rate at which the post -cure properties are developing. Optimum cure efficiency is obtained at a level of approximately 20% by weight of propylene carbonate, corresponding to a weight ratio of approximately 4 UVR6105 : 1 propylene carbonate and a molar ratio of around 3.8 epoxide groups to 1 carbonate.

### EXAMPLE 2

Varnish formulations were prepared based on 2% Meerkat photoinitiator, 0.1% Tegorad 2100 wetting aid, variable levels of ethylene, vinyl ethylene or glycerine carbonate (as shown in Tables 2-4), with the remainder being UVR6105 cycloaliphatic epoxide. All formulations also contain 1% of propylene carbonate which is used in a photoinitiator concentrate when preparing the samples. All formulations were printed using a number 1 K bar onto Leneta charts and cured with a single pass at 100 m/min using 1x 118W/cm (300 W/inch) medium pressure mercury lamp operating at half power. Cure was assessed using the well known MEK solvent rub method immediately after cure, 5 minutes after cure and 15 minutes after cure. The results are shown in the following Tables 2-4.

**Table 2**

| % ethylene carbonate | MEK double rubs | | |
|---|---|---|---|
| | Immediate | T= 5 minutes | T= 15 minutes |
| 0 | 3 | 5 | 5 |
| 5 | 3 | 10 | 23 |
| 10 | 3 | 36 | > 50 |
| 15 | 5 | > 50 | > 50 |
| 20 | 11 | > 50 | > 50 |
| 25 | 9 | > 50 | > 50 |
| 30 | 6 | 47 | > 50 |

**Table 3**

| % vinyl ethylene carbonate | MEK double rubs | | |
|---|---|---|---|
| | Immediate | T= 5 minutes | T= 15 minutes |
| 0 | 6 | 12 | 8 |
| 2.5 | 8 | 20 | 29 |
| 5 | 6 | 17 | 39 |
| 10 | 9 | 48 | > 50 |
| 15 | 10 | > 50 | > 50 |
| 20 | 9 | 40 | > 50 |
| 25 | 7 | 13 | 30 |
| 30 | 8 | 9 | 13 |

**Table 4**

| % glycerine carbonate | MEK double rubs | | |
|---|---|---|---|
| | Immediate | T= 5 minutes | T= 15 minutes |
| 0 | 7 | 10 | 10 |
| 5 | 7 | 14 | 21 |
| 10 | 7 | 18 | 40 |
| 15 | 6 | 28 | > 50 |
| 20 | 7 | 29 | > 50 |
| 25 | 7 | 20 | 28 |
| 30 | 9 | 9 | 4 |
| 40 | 5 * | 5 | 9 |

| | | | |
|---|---|---|---|
| * coating tacky or wet | | | |

These results indicate that all the simple 5 membered cyclic carbonates tested demonstrate a strong post-cure promoting effect similar to that observed with propylene carbonate in Example 1.
- *Ethylene carbonate and vinyl ethylene carbonate were obtained from Aldrich*
- *Glycerine carbonate was obtained from Huntsman as Jeffsol GC*

### EXAMPLE 3

Varnish formulations were prepared based on 2% Meerkat photoinitiator, 0.1 % Tegorad 2100 wetting aid, 0%, 5% or 20% propylene carbonate with the remainder being UVR6105 cycloaliphatic epoxide. All formulations were printed using a number 1 K bar onto Leneta charts and cured at a range of UV doses by changing the lamp power and line speed. UV dose was measured using an EIT Uvicure light bug measuring only in the UVB region of the spectrum. Cure was assessed using the well known MEK solvent rub method immediately after cure and 1 hour after cure. The results are shown in Tables 5 and 6.

**Table 5**

| MEK double rubs immediately after cure | | | | | |
|---|---|---|---|---|---|
| UVB dose J/cm² | Line speed m/min | Lamp power | Immediate MEK double rubs | | |
| | | | 0% propylene carbonate | 5% propylene carbonate | 20% propylene carbonate |
| 0.018 | 120 | Half | 2 | 3 | 9 |
| 0.022 | 100 | Half | 2 | 2 | 8 |
| 0.027 | 80 | Half | 2 | 2 | 9 |
| 0.031 | 120 | Full | 3 | 3 | 9 |
| 0.035 | 60 | Half | 2 | 2 | 12 |
| 0.038 | 100 | Full | 2 | 3 | 11 |
| 0.046 | 80 | Full | 2 | 3 | 20 |
| 0.053 | 40 | Half | 2 | 2 | 11 |
| 0.061 | 60 | Full | 2 | 3 | 22 |
| 0.073 | 50 | Full | 2 | 3 | 48 |
| 0.091 | 40 | Full | 1 | 2 | > 50 |
| 0.109 | 20 | Half | 2 | 2 | 48 |
| 0.124 | 30 | Full | 1 | 3 | > 50 |
| 0.186 | 20 | Full | 1 | 2 | > 50 |
| 0.232 | 10 | Half | 1 | 2 | > 50 |
| 0.251 | 15 | Full | 1 | 2 | > 50 |
| 0.372 | 10 | Full | 1 | 3 | > 50 |

**Table 6**

| MEK double rubs 1 hour after cure | | | | | |
|---|---|---|---|---|---|
| UVB dose J/cm^{z} | Line speed m/min | Lamp power | MEK double rubs after 1 hour | | |
| | | | 0% propylene carbonate | 5% propylene carbonate | 20% propylene carbonate |
| 0.018 | 120 | Half | 5 | 27 | > 50 |
| 0.022 | 100 | Half | 7 | 36 | > 50 |
| 0.027 | 80 | Half | 7 | 40 | > 50 |
| 0.031 | 120 | Full | 6 | 26 | > 50 |
| 0.035 | 60 | Half | 9 | 39 | > 50 |
| 0.038 | 100 | Full | 6 | 48 | > 50 |
| 0.046 | 80 | Full | 6 | 40 | > 50 |
| 0.053 | 40 | Half | 5 | 40 | > 50 |
| 0.061 | 60 | Full | 4 | 48 | > 50 |
| 0.073 | 50 | Full | 3 | 42 | > 50 |
| 0.091 | 40 | Full | 2 | 32 | > 50 |
| 0.109 | 20 | Half | 3 | 43 | > 50 |
| 0.124 | 30 | Full | 2 | 25 | > 50 |
| 0.186 | 20 | Full | 2 | 13 | > 50 |
| 0.232 | 10 | Half | 2 | - | > 50 |
| 0.251 | 15 | Full | 2 | 13 | > 50 |
| 0.372 | 10 | Full | 2 | 9 | > 50 |

These results indicate that in cationic formulations based on cycloaliphatic epoxide, in the absence of, or at relatively low levels (5%) of, propylene carbonate the cure and post-cure reaction is either unaffected or retarded by increasing UV dose. Conversely, at high levels of propylene carbonate (20%) this effect is completely reversed and both cure and post-cure are significantly enhanced with increasing UV dose. All samples in this example cured tack free with a single pass.

### EXAMPLE 4

Varnish formulations were prepared based on different types of cationic photoinitiator, 0.1% Tegorad 2100 wetting aid, low and high levels of propylene carbonate, with the balance of the formulation being UV6105 cycloaliphatic epoxide.

All formulations were printed using a number 1 K bar onto Leneta charts and cured with a single pass at 100 m/min using 1x 118 W/cm (300 W/inch) medium pressure mercury lamp operating at half power. Cure was assessed using the well known MEK solvent rub method at various time intervals after cure. The results are shown in Table 7.

**Table 7**

| Photoinitiator | % propylene carbonate | MEK double rubs | | |
|---|---|---|---|---|
| | | Immediate | T= 5 minutes | T= 15 minutes |
| 2% Meerkat | 1 * | 7 | 10 | 11 |
| 2% Meerkat | 20 | 13 | > 50 | > 50 |
| 4% UVI6992 | 2 ** | 2 | 4 | 4 |
| 4% UVI6992 | 20 | 7 | > 50 | > 50 |
| 2% IGM 440 1% Irgacure 184 | 0 | 3 | 2 | 2 |
| 2% IGM 440 1% Irgacure 184 | 20 | 6 | > 50 | > 50 |

| | | | | |
|---|---|---|---|---|
| * used in the photoinitiator concentrate solution when preparing samples ** photoinitiator supplied commercially as 50% solution in propylene carbonate • *IGM 440 is 4,4'-dimethyl-dipheny*/ *iodonium hexafluorophosphate from IGM* • *Irgacure 184 is 1-hydroxycyclohexyl phenyl ketone ex CIBA, which is both a free radical photoinitiator and a well known sensitiser of iodonium salt cationic photoinitiators* • *UV1 6992 is a mixture of triaryl sulphonium salt compounds supplied as a 50 % solution in propylene carbonate by DOW* | | | | |

These results demonstrate that the cure benefit resulting from the use of high levels of propylene carbonate is independent of the type of cationic photoinitiator system used.

### EXAMPLE 5

White ink formulations suitable for flexographic printing were prepared based on;

| | |
|---|---|
| 3.6% | Meerkat photoinitiator |
| 1.0% | Solsperse 32000 pigment dispersion aid ex. Lubrizol |
| 0.2% | Airex 920 anti-foam ex. Tego |
| 40.0 % | Finnititan RDI/S Titanium dioxide pigment ex. Kemira OY |
| 5 - 22.5% | propylene carbonate |
| 50.2 - 32.7 % | UVR6105 cycloaliphatic epoxide |

All formulations were printed using an "Easiproof" hand anilox coater using a #300/32 anilox onto PET (polyethylene terephthalate) substrate and cured with a single pass at 146 m/min using 1 x 118 W/cm (300 W/inch) medium pressure mercury lamp operating at full power. Cure was assessed using the well known IPA (isopropyl alcohol) solvent rub method 25 seconds and 15 minutes after cure. The results are shown in the following Table 8

**Table 8**

| % propylene carbonate | % UVR 6105 | IPA rubs | | |
|---|---|---|---|---|
| | | Weight ratio UVR6105: propylene carbonate | T= 25 seconds | T=15 minutes |
| 5 | 50.2 | 10.0 | 8 | 65 |
| 7.5 | 47.7 | 6.4 | 8 | 80 |
| 10 | 45.2 | 4.5 | 12 | > 100 |
| 12.5 | 42.7 | 3.4 | 11 | > 100 |
| 15 | 40.2 | 2.7 | 12 | 43 |
| 17.5 | 37.7 | 2.2 | 12 | 34 |
| 20 | 35.2 | 1.8 | 5 | 20 |
| 22.5 | 32.7 | 1.4 | 4 | 4 |

These results in white ink formulations support those of Example 1 and demonstrate that optimum cure efficiency is obtained at a level of approximately 10 to 12.5% by weight of propylene carbonate, corresponding to a weight ratio of between 3.4 & 4.5 war6105 : 1 propylene carbonate.

### Comparative Example 1

Varnish formulations were prepared based on 2% Meerkat photoinitiator, 0.1% Tegorad 2100 wetting aid, variable levels of ε-caprolactone with the remainder being UVR6105 cycloaliphatic epoxide. All formulations also contain 1% of propylene carbonate which is used in a photoinitiator concentrate when preparing the samples. All formulations were printed using a number 1 K bar onto Leneta charts and cured with a single pass at 100m/min using 1x 118W/cm (300 W/inch) medium pressure mercury lamp operating at half power. Cure was assessed using the well known MEK solvent rub method immediately after cure, 5 minutes after cure and 15 minutes after cure. The results are shown in the following Table 9.

**Table 9**

| % e-caprolactone | MEK double rubs | | |
|---|---|---|---|
| | Immediate | T= 5 minutes | T=15 minutes |
| 0 | 5 | 7 | 12 |
| 2.5 | 6 | 8 | 10 |
| 5 | 5 | 8 | 9 |
| 10 | 5 | 9 | 12 |
| 15 | 5 | 9 | 12 |
| 20 | 5 * | 7 | 11 |
| 25 | 5 * | 7 | 7 |
| 30 | 4 * | 6 | 4 |

| | | | |
|---|---|---|---|
| * coating tacky or wet | | | |

These results indicate that, although ε-caprolactone is an effective diluent with similar viscosity and viscosity reducing power to propylene carbonate, it has no influence on the promotion of post-cure in the printed formulation and, by inference, plays no significant part in the chemical reactions taking place during the initial cure and post-cure processes.

### Comparative Example 2

Varnish formulations were prepared based on 2% Meerkat photoinitiator, 0.1 % Tegorad 2100 wetting aid, variable levels of RAPICURE PEPC with the remainder being UVR6105 cycloaliphatic epoxide. AU formulations also contain 1% of propylene carbonate which is used in a photoinitiator concentrate when preparing the samples. AU formulations were printed using a number 1 K bar onto Leneta charts and cured with a single pass at 100 m/min using 1x 118 W/cm (300 W/inch) medium pressure mercury lamp operating at half power. Cure was assessed using the well known MEK solvent rub method immediately after cure, 5 minutes after cure and 15 minutes after cure. The results are shown in the following Table 10.

**Table 10**

| % RAPICURE PEPC | | MEK double rubs | |
|---|---|---|---|
| | Immediate | T= 5 minutes | T=15 minutes |
| 0 | 4 | 9 | 14 |
| 2.5 | 4 | 7 | 13 |
| 5 | 4 | 10 | 17 |
| 10 | 5 | 8 | 25 |
| 15 | 5 | 10 | 21 |
| 20 | 4 * | 7 | 13 |
| 25 | 4 * | 5 | 7 |
| 30 | 4 * | 4 | 6 |

| | | | |
|---|---|---|---|
| * coating tacky or wet *RAPICURE PEPC (propenyl ether of propylene carbonate) was obtained from International Specialty Products (ISP)* | | | |

These results indicate that, although RAPICURE PEPC is also effective at promoting post-cure in the printed formulation, it is by no means as effective at doing so as simple aliphatic carbonates such as propylene and ethylene carbonate.

### Comparative Example 3

Varnish formulations were prepared based on increasing levels of Meerkat photoinitiator, 0.1 % Tegorad 2100 wetting aid and UVR6105 cycloaliphatic epoxide. All formulations contain 4% of propylene carbonate. All formulations were printed using an "Easiproof' hand anilox coater using a #300/41 anilox onto Leneta charts and cured with a single pass at 100 m/min using 1x 118 W/cm (300 W/inch) medium pressure mercury lamp operating at half power. Cure was assessed using the well known MEK solvent rub method immediately after cure, 5 minutes after cure and 15 minutes after cure. The results are shown in the following Table 11.

**Table 11**

| % Photoinitiator | MEK double rubs | | |
|---|---|---|---|
| | Immediate | T= 5 minutes | T= 15 minutes |
| 1 | Sample fails to cure | | |
| 1.5 | 5 | 4 | 6 |
| 2 | 5 | 5 | 6 |
| 2.5 | 5 | 10 | 9 |
| 3 | 5 | 7 | 12 |
| 3.5 | 5 | 8 | 12 |
| 4 | 5 | 8 | 14 |
| 4.5 | 6 | 12 | 15 |
| 5 | 5 | 11 | 17 |
| 6 | 5 | 11 | 16 |
| 7 | 5 | 9 | 15 |
| 8 | 5 | 6 | 14 |

These results indicate that at a constant low level of cyclic carbonate the level of photoinitiator has no effect on promoting post-cure in the printed formulations.

## Claims

1. An energy-curable coating composition an epoxide momer or oligomer, a cationic photoinitiator and a cyclic carbonate, provided that the composition does not comprise 57.1 % 3,4-epoxy-cyclohexylmethyl-3',4'-epoxycyclohexane carboxylate, 10.0% 3-ethyl-3-hydroxymethyl-oxctane, 15.0% pigment, 17.4% 10-biphenyl-4-yl-2-isopropyl-9-oxo-9H-thioxanthen-10-ium hexafluorophosphate as a 23% solution in propylene carbonate, and 0.5% levelling additive, and provided that when propylene carbonate is the only cyclic carbonate present, it is in an amount of at least 12% by weight of the entire composition.

2. A composition according to claim 1, in which the cyclic carbonate is present in an amount of from 12% to 35% by weight of the entire composition.

3. A composition according to claim 2, in which the cyclic carbonate is present in an amount of from 12% to 30% by weight of the entire composition.

4. A composition according to claim 3, in which the cyclic carbonate is present in an amount of from 12% to 25% by weight of the entire composition.

5. A composition according to claim 1, in which the cyclic carbonate is present in an amount of at least 15% by weight of the entire composition.

6. A composition according to claim 5, in which the cyclic carbonate is present in an amount of from 15% to 35% by weight of the entire composition.

7. A composition according to claim 6, in which the cyclic carbonate is present in an amount of from 15% to 25% by weight of the entire composition.

8. A composition according to claim 1, in which the cyclic carbonate is present in an amount of at least 7% by weight of the entire composition.

9. A composition according to claim 8, in which the cyclic carbonate is present in an amount of at least 8% by weight of the entire composition.

10. A composition according to claim 9, in which the cyclic carbonate is present in an amount of from 8% to 35% by weight of the entire composition.

11. A composition according to claim 10, in which the cyclic carbonate is present in an amount of at least 10% by weight of the entire composition.

12. A composition according to claim 11, in which the cyclic carbonate is present in an amount of from 10% to 30% by weight of the entire composition.

13. A composition according to any one of the preceding claims, comprising an oxetane monomer or oligomer.

14. A composition according to claim 13, in which the oxetane is 3-ethyl-3-hydroxymethyl-oxetane or 3-ethyl-3-[(2-ethylhexyloxy)methyl]oxetane.

15. A composition according to any one of the preceding claims, in which the cyclic carbonate is propylene carbonate, glycerine carbonate, vinyl ethylene carbonate, ethylene carbonate or butylene carbonate.

16. A composition according to claim 15, in which the cyclic carbonate is propylene carbonate.

17. A composition according to any one of the preceding claims, in the form of a printing ink or varnish.

18. A composition according to any one of the preceding claims, formulated for inkjet printing.

19. A process for preparing a cured coating composition, which comprises applying a composition according to any one of the preceding claims to a substrate and exposing the coated substrate to curing radiation to cure the coating.

20. A process according to claim 19, in which the curing radiation is ultraviolet.

## Patentansprüche

1. Energiehärtbare Beschichtungszusammensetzung umfassend ein Epoxid-Monomer oder -Oligomer, einen kationischen Photoinitiator und ein zyklisches Carbonat, mit der Maßgabe, dass die Zusammensetzung nicht 57,1 % 3,4-Epoxy-cyclohexylmethyl-3',4'-epoxycyclohexancarboxylat, 10,0 % 3-Ethyl-3-hydroxymethyloxetan, 15,0 % Pigment, 17,4 % 10-Biphenyl-4-yl-2-isopropyl-9-oxo-9H-thioxanthen-10-ium-hexafluorophosphat als eine 23 %-ige Lösung in Propylencarbonat, sowie 0,5 % Verlaufsadditiv umfasst, und mit der Maßgabe, dass Propylencarbonat in einer Menge von zumindest 12 Gew.-% der gesamten Zusammensetzung vorliegt, wenn es das einzige vorliegende zyklische Carbonat ist.

2. Zusammensetzung nach Anspruch 1, in welcher das zyklische Carbonat in einer Menge von 12 Gew.-% bis 35 Gew.-% der gesamten Zusammensetzung vorliegt.

3. Zusammensetzung nach Anspruch 2, in welcher das zyklische Carbonat in einer Menge von 12 Gew.-% bis 30 Gew.-% der gesamten Zusammensetzung vorliegt.

4. Zusammensetzung nach Anspruch 3, in welcher das zyklische Carbonat in einer Menge von 12 Gew.-% bis 25 Gew.-% der gesamten Zusammensetzung vorliegt.

5. Zusammensetzung nach Anspruch 1, in welcher das zyklische Carbonat in einer Menge von zumindest 15 Gew.-% der gesamten Zusammensetzung vorliegt.

6. Zusammensetzung nach Anspruch 5, in welcher das zyklische Carbonat in einer Menge von 15 Gew.-% bis 35 Gew.-% der gesamten Zusammensetzung vorliegt.

7. Zusammensetzung nach Anspruch 6, in welcher das zyklische Carbonat in einer Menge von 15 Gew.-% bis 25 Gew.-% der gesamten Zusammensetzung vorliegt.

8. Zusammensetzung nach Anspruch 1, in welcher das zyklische Carbonat in einer Menge von zumindest 7 Gew.-% der gesamten Zusammensetzung vorliegt.

9. Zusammensetzung nach Anspruch 8, in welcher das zyklische Carbonat in einer Menge von zumindest 8 Gew.-% der gesamten Zusammensetzung vorliegt.

10. Zusammensetzung nach Anspruch 9, in welcher das zyklische Carbonat in einer Menge von 8 Gew.-% bis 35 Gew.-% der gesamten Zusammensetzung vorliegt.

11. Zusammensetzung nach Anspruch 10, in welcher das zyklische Carbonat in einer Menge von zumindest 10 Gew.-% der gesamten Zusammensetzung vorliegt.

12. Zusammensetzung nach Anspruch 11, in welcher das zyklische Carbonat in einer Menge von 10 Gew.-% bis 30 Gew.-% der gesamten Zusammensetzung vorliegt.

13. Zusammensetzung nach einem der vorhergehenden Ansprüche, umfassend ein Oxetan-Monomer oder -Oligomer.

14. Zusammensetzung nach Anspruch 13, in welcher das Oxetan 3-Ethyl-3-hydroxymethyl-oxetan oder 3-Ethyl-3-[(2-ethylhexyloxy)methyl]oxetan ist.

15. Zusammensetzung nach einem der vorhergehenden Ansprüche, in welcher das zyklische Carbonat Propylencarbonat, Glycerincarbonat, Vinylethylencarbonat, Ethylencarbonat oder Butylencarbonat ist.

16. Zusammensetzung nach Anspruch 15, in welcher das zyklische Carbonat Propylencarbonat ist.

17. Zusammensetzung nach einem der vorhergehenden Ansprüche in Form einer Druckfarbe oder eines Lacks.

18. Zusammensetzung nach einem der vorhergehenden Ansprüche, die für den Tintenstrahldruck hergestellt ist.

19. Verfahren zur Herstellung einer gehärteten Beschichtungszusammensetzung, welches das Aufbringen einer Zusammensetzung nach einem der vorhergehenden Ansprüche auf ein Substrat und das Aussetzen des beschichteten Substrates einer Härtungsbestrahlung zur Härtung der Beschichtung umfasst.

20. Verfahren nach Anspruch 19, in welcher die Härtungsbestrahlung UV-Strahlung ist.

## Revendications

1. Composition de revêtement durcissable par énergie contenant un monomère ou un oligomère d'époxyde, un photoinitiateur cationique et un carbonate cyclique à condition que la composition ne comprenne pas 57,1 % de carboxylate de 3,4-époxy-cyclohexylméthyl-3',4'-époxycyclohexane, 10,0 % de 3-éthyl-3-hydroxyméthyl-oxétane, 15,0 % de pigment, 17,4 % d'hexafluorophosphate de 10-biphényl-4-yl-2-isopropyl-9-oxo-9H-thioxanthèn-10-ium comme solution à 23 % dans du carbonate de propylène, et 0,5 % d'additif de nivellement, et à condition que lorsque le carbonate de propylène est l'unique carbonate cyclique présent, il l'est dans une quantité d'au moins 12 % en poids de la composition totale.

2. Composition selon la revendication 1, dans laquelle le carbonate cyclique est présent dans une quantité de 12 à 35 % en poids de la composition totale.

3. Composition selon la revendication 2, dans laquelle le carbonate cyclique est présent dans une quantité de 12 % à 30 % en poids de la composition totale.

4. Composition selon la revendication 3, dans laquelle le carbonate cyclique est présent dans une quantité de 12 % à 25 % en poids de la composition totale.

5. Composition selon la revendication 1, dans laquelle le carbonate cyclique est présent dans une quantité d'au moins 15 % en poids de la composition totale.

6. Composition selon la revendication 5, dans laquelle le carbonate cyclique est présent dans une quantité de 15 % à 35 % en poids de la composition totale.

7. Composition selon la revendication 6, dans laquelle le carbonate cyclique est présent dans une quantité de 15 % à 25 % en poids de la composition totale.

8. Composition selon la revendication 1, dans laquelle le carbonate cyclique est présent dans une quantité d'au moins 7 % en poids de la composition totale.

9. Composition selon la revendication 8, dans laquelle le carbonate cyclique est présent dans une quantité d'au moins 8 % en poids de la composition totale.

10. Composition selon la revendication 9, dans laquelle le carbonate cyclique est présent dans une quantité de 8 % à 35 % en poids de la composition totale.

11. Composition selon la revendication 10, dans laquelle le carbonate cyclique est présent dans une quantité d'au moins 10 % en poids de la composition totale.

12. Composition selon la revendication 11, dans laquelle le carbonate cyclique est présent dans une quantité de 10 % à 30 % en poids de la composition totale.

13. Composition selon l'une quelconque des revendications précédentes comprenant un monomère ou un oligomère d'oxétane.

14. Composition selon la revendication 13, dans laquelle l'oxétane est le 3-éthyl-3-hydroxyméthyl-oxétane ou le 3-éthyl-3-[(2-éthylhexyloxy)méthyl]oxétane.

15. Composition selon l'une quelconque des revendications précédentes, dans laquelle le carbonate cyclique est le carbonate de propylène, le carbonate de glycéryle, le carbonate de vinyléthylène, le carbonate d'éthylène ou le carbonate de butylène.

16. Composition selon la revendication 15, dans laquelle le carbonate cyclique est le carbonate de propylène.

17. Composition selon l'une quelconque des revendications précédentes dans la forme d'une encre d'impression ou d'un vernis.

18. Composition selon l'une quelconque des revendications précédentes formulée pour une impression par jet d'encre.

19. Procédé de préparation d'une composition de revêtement durcie, lequel comprend l'application d'une composition selon l'une quelconque des revendications précédentes sur un substrat et l'exposition du substrat revêtu à un rayonnement de durcissement pour faire durcir le revêtement.

20. Procédé selon la revendication 19, dans lequel le rayonnement de durcissement est ultraviolet.
